(19) Europäisches Patentamt / European Patent Office / Office européen des brevets

(11) **EP 1 870 771 A2**

(12) **EUROPEAN PATENT APPLICATION**


(43) Date of publication:
**26.12.2007 Bulletin 2007/52**

(21) Application number: **07252494.5**

(22) Date of filing: **20.06.2007**

(51) Int Cl.:
***G03F 7/00*** *(2006.01)* ***G03F 7/004*** *(2006.01)*
***G03F 7/033*** *(2006.01)*

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **20.06.2006 KR 20060055410**



(71) Applicant: **Samsung SDI Co., Ltd.**
**Suwon-si, Gyeonggi-do (KR)**

(72) Inventors:
- **Lee, Beom-Wook**
**Suwon-si**
**Gyeonggi-do (KR)**
- **Choi, Jong-Seo**
**Suwon-si**
**Gyeonggi-do (KR)**
- **Choi, Kwi-Seok**
**Suwon-si**
**Gyeonggi-do (KR)**
- **Lim, Myung-duk**
**Suwon-si**
**Gyeonggi-do (KR)**
- **Lee, Hoon-Bae**
**Suwon-si**
**Gyeonggi-do (KR)**
- **Chang, Bum-Jin**
**Suwon-si**
**Gyeonggi-do (KR)**

(74) Representative: **Mounteney, Simon James**
**Marks & Clerk**
**90 Long Acre**
**London WC2E 9RA (GB)**


(54) **Photosensitive paste composition, barrier rib prepared using the composition and plasma display panel comprising the barrier rib**


(57) A photosensitive paste composition includes a metal oxide sol and an inorganic material, wherein the average light refractive index ($N_1$) of the metal oxide sol and the average light refractive index ($N_2$) of the inorganic material satisfy Equation 1 below, a barrier rib of a PDP prepared using the same and a PDP including the barrier rib:

Equation 1

$$-0.2 \leq N_1 - N_2 \leq 0.2.$$

A barrier rib of a plasma display panel (PDPis prepared using the photosensitive paste composition. Since a pattern of a barrier rib for a PDP having high resolution and high precision can be made by only a single exposure to light, and a barrier rib having a higher reflective index than a conventional barrier rib can also be provided, a PDP including the barrier rib can have a high luminance.


FIG. 1

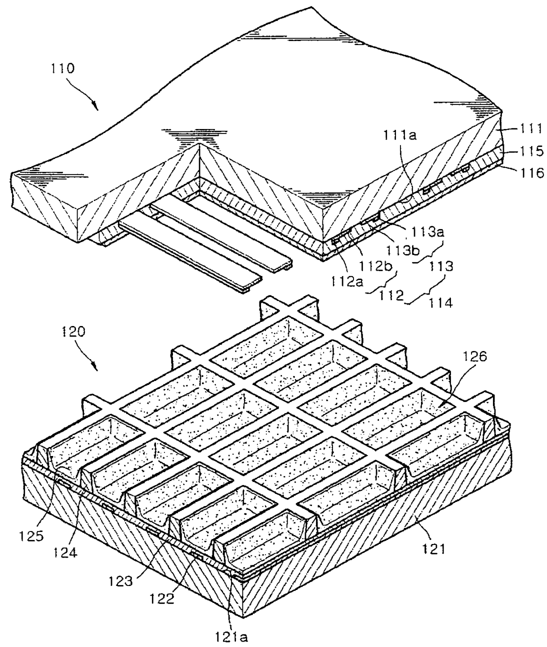


EP 1 870 771 A2

## Description

## BACKGROUND OF THE INVENTION

1. Field of the Invention

Aspects of the present invention relate to a photosensitive paste composition, a barrier rib of a plasma display panel (PDP) prepared using the photosensitive paste composition and a PDP including the barrier rib. More particularly, aspects of the present invention relate to a photosensitive paste composition that can be used to make a pattern of a barrier rib for a PDP having high resolution and high precision while requiring only a single exposure to light and that can be used to make a barrier rib having a higher reflective index (reflextivity) than a conventional barrier rib, a barrier rib of a PDP prepared using the photosensitive paste composition and a PDP including the barrier rib.

2. Description of the Related Art

In PDPs, a barrier rib is a structure formed on a rear panel (or a rear substrate), and serves to define a discharge space and to prevent electrical or optical crosstalk between adjacent discharge cells. Such a barrier rib may have various shapes (such as, for example, in the form of stripes or a matrix) and may have various sizes (according to variations in width and pitch) depending on the type of PDP.
The barrier rib is formed on a dielectric layer covering address electrodes on a lower substrate of a PDP using, for example, a screen printing method, a sand blasting method, etching, photolithography, or the like.
When a barrier rib is formed using a screen printing method, a barrier rib paste for printing is printed on a substrate using a patterned mask and a squeegee and is dried to remove a solvent. The printing and drying are repeated several times to obtain a film with a desired thickness. The obtained film is sintered to thereby form a barrier rib. However, this method is time-consuming, and it is difficult to form a uniformly patterned barrier rib due to misalignment created by low resolution and repeated printing.
When a barrier rib is formed using a sand blasting method, a barrier rib paste is printed once on a substrate by a table coater and is dried to obtain a film with a desired thickness. A dry film resist with sanding resistance is then laminated on the film and patterned through exposure to light and development. Then, micro-abrasive sandblasting is performed under high pressure using the dry film resist pattern as a mask to obtain a patterned film. The residual dry film resist is removed and the patterned film is sintered to complete the barrier rib. Although a barrier rib formed by sandblasting has higher resolution than a barrier rib formed by screen printing, the sandblasting method has disadvantages such as the complicated process and the risk of damage to electrode terminals due to contact with abrasive sand.
Etching is a similar method to sand blasting, the difference being that with an etching process, the barrier rib is formed by patterning a sintered membrane using an etching solution. Using etching, high resolution is possible, but the manufacturing cost is high.
When a barrier rib is formed using photolithography, as disclosed, for example, in U.S. Patent No. 5,209,688, a photosensitive paste is printed and dried to form a film with a desired thickness. The film is exposed to UV light by a UV exposure system equipped with a photomask. The printing, drying, and exposure are repeated twice. Developing is then performed to selectively remove an unexposed region, followed by sintering, to obtain a barrier rib. Photolithography can form a barrier rib with higher resolution relative to screen printing and does not require a dry film resist and a sanding process unlike a sandblasting method. However, there are disadvantages to the conventional photolithography process, including the requirement of repetition of processes and the risk of misalignment due to the repeated processes.
Therefore, as disclosed in U.S. Patent Nos. 6,197,480, 6,507,148 and 6,576,391, methods have been developed for forming a barrier rib by single exposure photolithography by minimizing the difference between light refractive indices of inorganic and organic compounds in the photosensitive paste in order to minimize scattering and reflection of light irradiated at an interface between the inorganic and organic compound during the exposure. Most of the methods described in the above patents are widely used. However, the methods disclosed in the patents described above have the following problems.
First, to minimize the difference between light refractive indices of an inorganic compound and an organic compound, an inorganic compound or organic compound having a light refractive index in a specific range that is atypical has to be used. That is, since an inorganic compound of a barrier rib material that is generally used in a sand blasting method, etching or the like typically has a light refractive index of 1.60-1.80, and an organic compound thereof typically has a light refractive index of 1.50-1.60 or less, the difference between the light refractive indices of the inorganic compound and the organic compound cannot be minimized with inorganic compounds and organic compounds that are used in conventional barrier rib-forming processes. Therefore, since inorganic compounds typically used in forming barrier ribs have a high light refractive index and organic materials typically used in forming barrier ribs have a lower light refractive index, in order to minimize a difference between light refractive indices of an inorganic compound and

an organic compound, either an inorganic material having a low light refractive index has to be developed and used or an organic compound having a high refractive index has to be developed and used.

Secondly, specific organic materials having a high refractive index that have been used or proposed, have disadvantages. In particular, binders containing a Br atom are disadvantageous in that such materials may be harmful to human bodies. Further, monomers containing S are disadvantageous as being expensive.

Thirdly, in a sand blasting method, etching or the like, in order to maintain the shape of a barrier rib and increase the reflective index of a barrier rib or color a barrier rib in a sintering process, a powder such as titania, alumina, silica, zirconia oxide, yttria, magnesia, zinc oxide, manganese oxide, iron oxide, tin oxide, copper oxide, lead oxide, or the like is used in a predetermined amount. However, in the case of the methods disclosed in the above-mentioned patent applications relating to single-exposure lithography, powders having such components cannot be used. This is because the powders having such components have very high light refractive indices, and are thereby unable to minimize the difference of light refractive index between an organic compound and the powders. The powders interfere with the transmittance of ultraviolet rays irradiated during exposure to light so that a barrier rib can not be formed by a single exposure. Due to these problems, glass having a high melting point and low light refractive index and that is transparent to ultraviolet rays is used instead of the generally used powders having the components in the above-mentioned patent applications. As a result, barrier ribs prepared using the methods disclosed in the above-mentioned patents have a low reflective index. Thus, the reflectivity of visible rays emitted when a PDP operates is reduced, leading to a further reduced luminance compared with a barrier rib prepared using a sand blasting method or etching. Therefore, to compensate for these disadvantages, a method is used of compensating the reduced luminance, by making the width of the barrier rib narrower than that of a barrier rib prepared using other methods, and thus the area coated with phosphors is maximized.

Lastly, barrier ribs prepared using the methods disclosed in the above-mentioned patents have a higher membrane surface roughness compared with barrier ribs prepared using other methods. The reason is as follows: to form a barrier rib by a single light exposure, ultraviolet rays irradiated during the exposure have to reach the bottom surface. For this to be possible, not only must the difference of light refractive indices of the inorganic compound and the organic compound be minimized, but also an inorganic compound having a relatively bigger particle diameter than that used in other methods (sanding or etching) has to be used. In addition, the surface of the portion that is exposed to light to be cured is taken off bit by bit by a developing solution in a developing process, and thus the surface becomes rough. The surface with roughness tends to maintain its shape after sintering, although it depends on the extent of sintering. Thus, the finally prepared barrier rib has higher surface roughness compared with barrier ribs prepared using other methods. When a membrane of the barrier rib becomes rough, the reflection efficiency with respect to visible rays is reduced, and thus crosstalk between discharge cells can be induced besides a reduction in luminance, and the breaking strength of a panel is reduced or noises caused by shaking of the upper and lower substrate can occur.

To increase the reflective index of a barrier rib to overcome the problems of the above-mentioned patents, Japanese Patent Laid-Open Publication No. 1999-102645 discloses a method of using titanium dioxide, alumina, zirconium oxide or silica powder in a predetermined amount. However, when these components are used, the difference of light refractive indices between the components and an organic compound is increased or ultraviolet rays irradiated can not be transmitted, and thus the exposure sensitivity is significantly reduced. Accordingly, a barrier rib with the desired shape can not be prepared by a single exposure to light.

In addition, Japanese Patent Laid-Open Publication No. 2000-290040, describes the use of 5-80 nm of titanium dioxide, alumina, silica, zirconium oxide, yttria, or the like. Moreover, Japanese Patent Laid-Open Publication No. 2004-318116 discloses a method of increasing the reflective index of a barrier rib by adding 5-80 nm of titanium dioxide, alumina, silica, zirconium oxide, yttria, magnesia, zinc oxide, manganese oxide, iron oxide, tin oxide, copper oxide or lead oxide. When particles having very small diameters compared with the wavelength of light irradiated during exposure to light are used, the particles do not cause scattering, reflection or the like with respect to light and cause an increase in the light refractive index of an organic compound, and there is no need for use of an inorganic compound having a low refractive index and an organic compound having a high refractive index. However, when a barrier rib is prepared by simply adding 5-80 nm of the particulate components described above, mixing, 3-roll milling and the like, the particulate components are not dispersed in a paste as a single particle state and become agglomerated with one another. Accordingly, the method disclosed in Japanese Patent Laid-Open Publication No. 2000-290040 has problems similar to those shown in Japanese Patent Laid-Open Publication No. 1999-102645.

Japanese Patent Laid-Open Publication No. 2002-122985 discloses a method of preparing a barrier rib of a PDP using a photosensitive paste containing a metal oxide sol. However, the fact that a component of the metal oxide sol affects the refractive index of an organic compound is disregarded, and only the difference of refractive indices between an organic compound and inorganic compound is intended to be minimized regardless of the refractive index of the metal oxide sol. Accordingly, this method still has the same problems as those shown in U.S. Patent Nos. 6,197,480, 6,507,148 and 6,576,391 described above.

## SUMMARY OF THE INVENTION

Aspects of the present invention provide a photosensitive paste composition that can be used to form a barrier rib for a plasma display panel (PDP) having high resolution and high precision. The barrier rib can be formed in a method that includes only a single exposure of the photosensitive paste to light. The photosensitive paste composition provides a barrier rib having a higher reflective index than a conventional barrier rib.

According to a first aspect of the present invention, there is provided photosensitive paste as set out in Claim 1. Preferred features of this aspect are set out in Claims 2 to 28.

According to a second aspect of the present invention, there is provided a barrier rib of a PDP prepared using the photosensitive paste composition of the first aspect.

According to a third aspect of the present invention, there is provided a PDP comprising the barrier rib of the second.

According to a fourth aspect of the present invention, there is provided a method of forming a barrier rib of a plasma display panel, the method comprising coating a substrate with a photosensitive paste composition comprising a metal oxide sol material comprising a metal oxide dispersed in an organic mixture; and an inorganic material, wherein the average optical refractive index (N1) of the metal oxide sol and the average optical refractive index (N2) of the inorganic material satisfy Equation 1 below:

Equation 1

$$0.2 \leq N1 - N2 \leq 0.2;$$

forming a barrier rib pattern on the substrate by photolithography of the photosensitive paste composition; and firing the substrate having the barrier rib pattern formed thereon to form the barrier rib.

According to another aspect of the present invention, there is provided a plasma display panel including at least one barrier rib, wherein the at least one barrier rib is formed by: coating a substrate with a photosensitive paste composition comprising: a metal oxide sol material comprising a metal oxide dispersed in an organic mixture; and an inorganic material, wherein the average optical refractive index ($N_1$) of the metal oxide sol and the average optical refractive index ($N_2$) of the inorganic material satisfy Equation 1 below:

Equation 1

$$0.2 \leq N_1 - N_2 \leq 0.2;$$

forming a barrier rib pattern on the substrate by photolithography of the photosensitive paste composition; and firing the substrate having the barrier rib pattern formed thereon to form the at least one barrier rib.

Additional aspects and/or advantages of the invention will be set forth in part in the description which follows and, in part, will be obvious from the description, or may be learned by practice of the invention.

## BRIEF DESCRIPTION OF THE DRAWINGS

These and/or other aspects and advantages of the invention will become apparent and more readily appreciated from the following description of the embodiments, taken in conjunction with the accompanying drawings of which:

FIG. 1 is a partially exploded perspective view of a PDP according to an embodiment of the present invention.

## DETAILED DESCRIPTION OF THE EMBODIMENTS

Reference will now be made in detail to the present embodiments of the present invention, examples of which are illustrated in the accompanying drawings, wherein like reference numerals refer to like elements throughout. The embodiments are described below in order to explain the present invention by referring to the figures.

Embodiments of the present invention will now be described in more detail. Embodiments of the present invention provide a photosensitive paste composition comprising a metal oxide sol and an inorganic material, wherein the average optical refractive index ($N_1$) of the metal oxide sol and the average light optical refractive index ($N_2$) of the inorganic material satisfy Equation 1 below:

Equation 1

$$0.2 \leq N_1 - N_2 \leq 0.2$$

Unlike a conventional photosensitive paste composition, the photosensitive paste composition of the present invention comprises a metal oxide sol. The metal oxide sol is a sol-state material in which a metal oxide having a diameter of several to tens of nm is dispersed in an organic mixture. The metal oxide is dispersed in the organic mixture in a stable state in which phenomena such as agglomeration or precipitation do not occur. The metal oxide sol can be used in combination with an inorganic material. A barrier rib prepared using the photosensitive paste composition comprising a metal oxide sol has a higher reflectivity than a conventional photosensitive barrier rib, and thus provides increased luminance, functions as a support in order that the shape of the barrier rib is not deformed in a sintering process, and provides increased compactness of the barrier rib, thereby reducing its surface roughness.

The metal component of the metal oxide sol can be, but is not limited to, at least one metal component selected from the group consisting of Si, Ti, Al, Zr, Ta, Ge, Y, Zn and the like. The metal oxide sol is generally prepared by preparing a metal oxide precursor from an alkoxide or halide compound using hydrolysis and condensation, and dispersing the prepared metal oxide precursor in an organic mixture. Herein, a surface modifier can be additionally introduced as desired in the process of preparing the metal oxide precursor.

In the preparation of the metal oxide precursor, the average particle diameter of the metal oxide is determined by the degree of the hydrolysis and condensation. As a non-limiting example, the metal oxide may preferably have an average particle diameter of 1-60 nm. As a more specific, non-limiting example, the metal oxide may have an average particle diameter of 2-40 nm. As an even more specific, non-limiting example, the metal oxide may have an average particle diameter of 4-20 nm. When the average particle diameter of the metal oxide is less than 1 nm, its preparation is difficult and it is difficult for the metal oxide to be uniformly dispersed in an organic mixture. When the average particle diameter of the metal oxide is greater than 60 nm, the metal oxide scatters light when exposed to light, and thus interferes with light transmittance.

The average light refractive index of the metal oxide of the metal oxide precursor may be in the range of 1.3-3.0. The average light refractive index of a metal oxide sol prepared by dispersing the metal oxide precursor in an organic mixture may be in the range of 1.4-2.0. When the average light refractive indices of the metal oxide precursor and the metal oxide sol are not within these ranges, it is difficult to prepare a photosensitive paste composition having a refractive index within the refractive index range given in Equation 1 above.

The term "average light refractive index of the metal oxide sol" refers to the average light refractive index measured in the absence of a solvent. The light refractive index of the metal oxide sol is measured using a light refractive index measuring apparatus by coating the metal oxide sol onto a transparent film or a glass substrate, and then drying the coated metal oxide sol for several to tens of minutes at a temperature in the range of 80-100°C.

In addition, in the preparation of the metal oxide sol by dispersing the metal oxide precursor in an organic mixture, the amount of the metal oxide may be 5-50 parts by volume with respect to 100 parts by volume of the organic mixture. When the amount of the metal oxide is less than 5 parts by volume with respect to 100 parts by volume of the organic mixture, the increase in the reflective index of the barrier rib is not great. When the amount of the metal oxide is greater than 50 parts by volume with respect to 100 parts by volume of the organic mixture, a crosslinking reaction is insufficiently performed when the metal oxide sol is exposed to light, and thus the barrier rib cannot have the desired shape.

When the metal oxide sol is mixed with an inorganic material, two relationships are taken into consideration. One is the relationship between the refractive index of the metal oxide sol and the inorganic material. In particular, the value of the refractive index of the metal oxide sol and the inorganic material may, as a non-limiting example, satisfy Equation 1 given above. As a more specific, non-limiting example, the value of the refractive index of the metal oxide sol and the inorganic material may satisfy Equation 2 below. As an even more specific, non-limiting example, the value of the refractive index of the metal oxide sol and the inorganic material may satisfy Equation 3 below.

Equation 2

$$0.1 \leq N_1 - N_2 \leq 0.1$$

Equation 3

$$0.05 \leq N_1 - N_2 \leq 0.05$$

where each of $N_1$ and $N_2$ is the same as defined in Equation 1.

When the relationship between the refractive indices of the metal oxide sol and the inorganic material is outside the range given in Equation 1, transmittance of light irradiated during exposure to light is reduced so that a barrier rib can not be formed by a single exposure. When the relationship between the refractive indices of the metal oxide sol and the inorganic material is within the range of Equation 3 given above, light exposure sensitivity is excellent, and the scattering of irradiated light is reduced so that the straightness of the barrier rib pattern is also excellent.

The amount of the metal oxide in the metal oxide sol with respect to the inorganic material in the photosensitive paste composition should also be taken into consideration, when the mixing ratio of metal oxide sol to the inorganic material is determined. As a non-limiting example, the amount of the metal oxide of the metal oxide sol is 3-30 parts by volume with respect to 100 parts by volume of the inorganic material.inorganic material As a more specific, non-limiting example, the amount of the metal oxide may be 5-20 parts by volume with respect to 100 parts by volume of the inorganic material. When the amount of the metal oxide is less than 3 parts by volume with respect to 100 parts by volume of the inorganic material, the increase in the reflective index of a barrier rib is not great. When the amount of the metal oxide is greater than 30 parts by volume with respect to 100 parts by volume of the inorganic material, the inorganic material cannot be fully sintered, and thus the compactness of the barrier rib is reduced.

The average thermal expansion coefficient a of the metal oxide and the inorganic material may satisfy Equation 4 below.

Equation 4

$$\text{Substrate thermal expansion coefficient} \times 0.9 \leq \alpha \leq \text{Substrate thermal expansion coefficient}$$

When the average thermal expansion coefficient of the metal oxide and the inorganic material is beyond the range of Equation 4, in the severe case, the substrate bends or breaks after sintering.

The inorganic material of the photosensitive paste composition used according to aspects of the present invention may have an average light refractive index within the range of 1.5-1.8. When the average light refractive index of the inorganic material is beyond this range, the difference between the light refractive index of the inorganic material and the light refractive index of the metal oxide sol is so large that a barrier rib can not be formed by a single exposure to light.

The inorganic material comprises a glass frit having a low melting point and a glass frit having a high melting point. The glass frit having a low melting point of the inorganic material is sintered in a sintering process, thereby forming a compact barrier rib membrane, and the glass frit having a high melting point maintains the shape of the barrier rib membrane in the sintering process.

The particle shape of the glass frit having a low melting point is not particularly limited, but, as a non-limiting example, may be spherical or almost spherical. The nearer the particle shape of the glass frit having a low melting point is to being spherical, the more improved are the characteristics with respect to the packing ratio and ultraviolet ray transmittance. The average particle diameter of the glass frit having a low melting point may have a median value $D_{50}$ of 2-5 $\mu$m, a minimum value $D_{min}$ of 0.1 $\mu$m and a maximum value $D_{max}$ of 20 $\mu$m. When the median value $D_{50}$ is less than 2 $\mu$m, or the minimum value $D_{min}$ is less than 0.1 $\mu$m, the dispersibility of the glass frit having a low melting point is reduced so that the printing properties are worsened, and the contraction ratio thereof is high in the sintering process so that a barrier rib having the desired shape cannot be obtained. When the median value $D_{50}$ is greater than 5 $\mu$m, or the maximum value $D_{max}$ is greater than 20 $\mu$m, the compactness and straightness of the barrier rib are reduced.

The softening temperature Ts of the glass frit having a low melting point may satisfy Equation 5 below.

Equation 5

$$\text{Sintering temperature} - 80\ ^\circ\text{C} < T_s < \text{sintering temperature}$$

When the softening temperature of the glass frit having a low melting point is less than the sintering temperature minus 80 °C, the shape of the barrier rib is deformed in the sintering process. When the softening temperature of the glass frit having a low melting point is greater than the sintering temperature, sintering is not fully performed.

The amount of the glass frit having a low melting point may be 70-100 parts by volume with respect to 100 parts by volume of the inorganic material. When the amount of the glass frit having a low melting point is less than 70 parts by volume with respect to 100 parts by volume of the inorganic material, sintering is not fully performed.

Examples of the glass frit having a low melting point include, but are not limited to, a complex oxide comprising at least three oxides selected from oxides of Pb, Bi, Si, B, Al, Ba, Zn, Mg, Ca, P, V, Mo, Te and the like. The glass frit having a low melting point can be used alone or in combination with two complex oxides. More particularly, the glass frit having a low melting point may comprise a material selected from a $PbO-B_2O_3$ based glass, a $PbO-SiO_2B_2O_3$ based glass, a $Bi_2O_3-B_2O_3$ based glass, a $Bi_2O_3-SiO_2-B_2O_3$ based glass, a $SiO_2B_2O_3-Al_2O_3$ based glass, a $SiO_2-B_2O_3-BaO$ based glass, a $SiO_2-B_2O_3-CaO$ based glass, a $ZnO-B_2O_3-Al_2O_3$ based glass, a $ZnO-SiO_2B_2O_3$ based glass, a $P_2O_5$ based glass, a $SnO-P_2O_5$ based glass, a $V_2O_5-P_2O_5$ based glass, a $V_2O_5-Mo_2O_3$ based glass, and a $V_2O_5-P_2O_5-TeO_2$ based glass.

The particle shape of the glass frit having a high melting point is not particularly limited, but, as a non-limiting example, may be spherical or almost spherical. The nearer the particle shape of the glass frit having a high melting point is to being spherical, the more improved are the characteristics with respect to the packing ratio and ultraviolet ray transmittance. The average particle diameter of the glass frit having a high melting point may have a median value of 1-4 μm, a minimum value of 0.1 μm and a maximum value of 20 μm. When the median value is less than 1 μm, or the minimum value is less than 0.1 μm, light exposure sensitivity is reduced and a contraction ratio is high in the sintering process so that a barrier rib having the desired shape cannot be obtained. When the median value is greater than 5 μm, or the maximum value is greater than 20 μm, the compactness and straightness of the barrier rib are reduced.

The softening temperature Ts of the glass frit having a high melting point may satisfy Equation 6 below.

Equation 6

$$T_s > \text{sintering temperature} + 20°C$$

When the softening temperature of the glass frit having a high melting point is less than the sintering temperature + 20°C, the shape of the barrier rib is deformed in the sintering process.

The amount of the glass frit having a high melting point may be 0-30 parts by volume with respect to 100 parts by volume of the inorganic material. When the amount of the glass frit having a high melting point is greater than 0-30 parts by volume with respect to 100 parts by volume of the inorganic material, sintering is not fully performed.

Examples of the glass frit having a high melting point include, but are not limited to, a complex oxide comprising at least three oxides selected from the group consisting of Si oxide, B oxide, Al oxide, Ba oxide, Zn oxide, Mg oxide, Ca oxide, and the like. The glass frit having a high melting point can be used alone or in combination with two complex oxides. More particularly, the glass frit having a high melting point may comprise a material selected from a $SiO_2-B_2O_3-BaO$ based glass, a $SiO_2-B_2O_3-CaO$ based glass, a $SiO_2-B_2O_3-MgO$ based glass, a $SiO_2-B_2O_3-CaO-BaO$ based glass, a $SiO_2-B_2O_3-CaO-MgO$ based glass, a $SiO_2-Al_2O_3-BaO$ based glass, a $SiO_2-Al_2O_3-CaO$ based glass, a $SiO_2-Al_2O_3-MgO$ based glass, a $SiO_2-Al_2O_3-BaO-CaO$ based glass, a $SiO_2-Al_2O_3-CaO-MgO$ based glass, and the like.

Average light refractive indices of the glass frit having a low melting point and the glass frit having a high melting point may be in the range of 1.5-1.8 as described above. In addition, the difference between the refractive index $N_3$ of the glass frit having a low melting point and the refractive index $N_4$ of the glass frit having a high melting point may satisfy Equation 7 below. As a specific, non-limiting example, the difference between the refractive index $N_3$ of the glass frit having a low melting point and the refractive index $N_4$ of the glass frit having a high melting point may satisfy Equation 8 below. As a specific, non-limiting example, the difference between the refractive index $N_3$ of the glass frit having a low melting point and the refractive index $N_4$ of the glass frit having a high melting point may satisfy Equation 9 below.

Equation 7

$$0.2 \leq N_3 - N_4 \leq 0.2$$

Equation 8

$$0.1 \leq N_3 - N_4 \leq 0.1$$

Equation 9

$$0.05 \leq N_3 - N_4 \leq 0.05$$

When the difference between the light refractive indices of the glass frit having a low melting point and the glass frit having a high melting point is beyond the range of Equation 7, transmittance of light irradiated during exposure to light is reduced so that a barrier rib cannot be formed by a single exposure to light.

The organic mixture used according to aspects of the present invention comprises a binder, a photo initiator and a cross linking agent. In addition, the organic mixture may comprise a solvent or additives used to improve characteristics of the paste and to adjust viscosity or the like.

For the binder, an acryl-based resin having a carboxyl group is generally used, which makes developing possible in an alkali developing solution and makes a characteristic adjustment according to a change in composition of components easy. The acryl-based resin having a carboxyl group makes it possible for developing to be performed in an aqueous alkali solution, makes it easier for inorganic components to be dispersed in the photosensitive paste composition, and provides appropriate viscosity and elasticity. The acryl-based resin having a carboxyl group can be prepared by copolymerization of a monomer having a carboxyl group and a monomer having an ethylene unsaturated group.

As a non-limiting example, the monomer having a carboxyl group may be at least one selected from the group consisting of an acrylic acid, a methacrylic acid, a fumaric acid, a maleic acid, a vinylacetic acid, and an anhydride thereof. As specific non-limiting examples, the monomer having an ethylene unsaturated group may be at least one selected from the group consisting of methyl(meth)acrylate, ethyl(meth)acrylate, n-propyl(meth)acrylate, isopropyl(meth)acrylate, n-butyl(meth)acrylate, sec-butyl(meth)acrylate, isobutyl(meth)acrylate, tert-butyl(meth)acrylate, n-pentyl(meth)acrylate, allyl(meth)acrylate, phenyl(meth)acrylate, benzyl(meth)acrylate, butoxyethyl(meth)acrylate, butoxytriethyleneglycol(meth)acrylate, cyclohexyl(meth)acrylate, dicyclopentanyl(meth)acrylate, dicyclopentenyl(meth)acrylate, 2-ethylhexyl(meth)acrylate, glycerol(meth)acrylate, glycidyl(meth)acrylate, isobornyl(meth)acrylate, isodecyl(meth)acrylate, isooctyl(meth)acrylate, lauryl(meth)acrylate, 2-methoxyethyl(meth)acrylate, methoxyethyleneglycol(meth)acrylate, methoxydiethyleneglycol(meth)acrylate, phenoxyethyl(meth)acrylate, stearyl(meth)acrylate, 1-naphthyl(meth)acrylate, 2-naphthyl(meth)acrylate, 2-hydroxyethyl(meth)acrylate, 2-hydroxypropyl(meth)acrylate, aminoethyl(meth)acrylate, styrene, a-methylstyrene, a-2-dimethylstyrene, 3-methylstyrene, 4-methylstyrene, and the like.

In addition, a cross-linkable group that can induce a cross-linking reaction between a monomer having a carboxyl group and an ethylenically unsaturated monomer may be further added to the binder. As non-limiting examples, the ethylenically unsaturated monomer may be selected from the group consisting of acryloylchloride, methacryloylchloride, allylchloride, glycidylacrylate, glycidylmethacrylate, 3,4-epoxycyclohexylmethylacrylate, and 3,4-epoxycyclohexylmethylmethacrylate, 3,4-epoxycyclohexylmethylmethacrylate and the like.

The copolymer can be used alone as the binder. However, for the purpose of enhancing the film leveling properties and/or thixotropic properties of the organic mixture, the copolymer may be mixed with an agent that enhances the film leveling properties and/or thixotropic properties. As a non-limiting example, the copolymer may be mixed with at least one selected from the group consisting of cellulose, methylcellulose, ethylcellulose, n-propylcellulose, hydroxyethylcellulose, 2-hydroxyethylcellulose, methyl-2-hydroxyethylcellulose, hydroxypropylcellulose, hydroxypropylmethylcellulose, hydroxybutylmethylcellulose, hydroxypropylmethylcellulose phthalate, cellulose nitrate, cellulose acetate, cellulose triacetate, cellulose acetate butylate, cellulose acetate hydrogenphthalate, cellulose acetate propionate, cellulose propionate, (acrylamidomethyl)cellulose acetate propionate, (acrylamidomethyl)cellulose acetate butylate, cyanoethylate cellulose, pectic acid, chitosan, chitin, carboxymethylcellulose, carboxymethylcellulose sodium salt, carboxyethylcellulose, and carboxyethylmethylcellulose.

The copolymer may have a weight average molecular weight in the range of 500-100,000 g/mol and an acid value of 50-300 mg KOH/g. If the weight average molecular weight of the copolymer is less than 500 g/mol, the dispersibility of the inorganic material in the paste is reduced. If the weight average molecular weight of the copolymer is greater than 100,000 g/mol, the developing speed is too slow or the developing is not performed. In addition, if the acid value of the copolymer is less than 50 mg KOH/g, the developing property deteriorates. If the acid value of the copolymer is greater than 300 mg KOH/g, even an exposed region may be developed.

The amount of binder may be 30-80 parts by weight with respect to 100 parts by weight of the organic mixture. When the amount of the binder is less than 30 parts by weight with respect to 100 parts by weight of the organic mixture, the coating property and dispersibility of the paste are reduced. When the amount of the binder is greater than 80 parts by weight with respect to 100 parts by weight of the organic mixture, a cross-linking reaction is insufficiently performed during exposure to light, and thus a pattern having the desired shape cannot be obtained.

The photo initiator produces radicals upon exposure to light, such as, for example, light irradiated by an exposure apparatus, and the produced radicals induce a polymerization reaction of the crosslinking agent having an ethylenically unsaturated group to create a product that is insoluble with respect to the developing solution. Since the photo initiator

requires high sensitivity, at least two of the following photo initiators may be combined. Examples of the photo initiator include, but are not limited to, combinations of (i) an imidazole-based compound, (ii) a triazine-based compound, (iii) an aminoacetophenone-based compound, (iv) a benzophenone and acetophenone based compound, (v) a benzoin-based compound, (vi) a titanocene-based compound, (vii) an oxadiazole-based compound, (viii) a thioxanthone-based compound, (ix) a (bis)acylphosphineoxide-based compound, and (x) an organic boron salt compound.

As non-limiting examples, the imidazole-based compound may be 2,2'-bis(o-chlorophenyl)-4,4',5,5'-tetraphenyl-1,2'-biimidazole, 2,2'-bis(o-bromophenyl)-4,4',5,5'-tetraphenyl -1,2'-biimidazole, 2,2'-bis(o-chlorophenyl)-4,4',5,5'-tetra(o,p-dichlorophenyl)-1,2'-biimidazole, 2,2'-bis(o,p-dichlorophenyl)-4,4',5,5'-tetra(o,p-dichlorophenyl)-1,2'-biimidazole, 2,2'-bis(o-chlorophenyl)-4,4',5,5'-tetra(m-methoxyphenyl)-1,2'-biimidazole, 2,2'-bis(o-methylphenyl)-4,4',5,5'-tetraphenyl-1,2'-biimidazole or the like.

As non-limiting examples, the triazine-based compound may be 2,4,6-tris(trichloromethyl)-s-triazine, 2,4,6-tris (tribromomethyl)-s-triazine, 2-propyonyl-4,6-bis(trichloromethyl)-s-triazine, 2-benzoyl-4,6-bis(trichloromethyl)-s-triazine, 2-(4-chlorophenyl)-4,6-bis(trichloromethyl)-s-triazine, 2-4-bis(4-methoxyphenyl)-6-trichloromethyl)-s-triazine, 2-(4-methoxyphenyl)-4,6-bis(trichloromethyl)-s-triazine, 2-(4-methoxystyryl)-4,6-bis(trichloromethyl)-s-triazine, 2-(4-chlorostyryl)-4,6-bis(trichloromethyl)-s-triazine, 2-(4-aminophenyl)-4,6-bis(trichloromethyl)-s-triazine, 2,4-bis(3-chlorophenyl)-6-trichloromethyl-s-triazine, 2-(4-aminostyryl)-4,6-bis(dichloromethyl)-s-triazine or the like.

As non-limiting examples, the aminoacetophenone compound may be 2-methyl-2-amino(4-morpholinophenyl) ethane-1-one, 2-ethyl-2-amino(4-morpholinophenyl)ethane-1-one, 2-propyl-2-amino(4-morpholinophenyl)ethane-1-one, 2-butyl-2-amino(4-morpholinophenyl)ethane-1-one, 2-methyl-2-amino(4-morpholinophenyl)propane-1-one, 2-methyl-2-amino(4-morpholinophenyl)butane-1-one, 2-ethyl-2-amino(4-morpholinophenyl)propane -1-one, 2-ethyl-2-amino (4-morpholinophenyl)butane-1-one, 2-methyl-2-methylamino(4-morpholinophenyl)propane-1-one, 2-methyl-2-dimethylamino(4-morpholinophenyl)propane-1-one, 2-methyl-2-diethylamino(4-morpholinophenyl)propane-1-one or the like.

As non-limiting examples, the benzophenone and acetophenone based compound may be benzophenone, 4-methylbenzophenone, 2,4,6-trimethylbenzophenone, methyl o-benzoylbenzoate, 4-phenylbenzophenone, 3,3'-dimethyl-4-methoxybenzophenone, 4-benzoyl-4'-methyldiphenylsulfide, 4,4'-bis(N,N-dimethylamino)benzophenone, 4,4'-bis (N,N-diethylamino)benzophenone, 3,3',4,4'-tetra(tert-butylperoxycarbonyl)benzophenone, (2- acryloyloxy ethyl)(4-benzoylbenzyl)dimethylammonium bromide, 4-(3-dimethylamino-2-hydroxypropyl)benzophenone, (4- benzoylbenzyl)trimethylammonium chloride, methochloride monohydrate, diethoxyacetophenone, 2-hydroxy-2-methyl-1-phenylpropane-1-one, 1-(4-isopropylphenyl)-2-methylpropane-1-one, 1-hydroxycyclohexylphenylketone, 4-tert-butyl-trichloroacetophenone or the like.

As non-limiting examples, the benzoin-based compound may be benzoin, benzoinmethylether, benzoinethylether, benzoinisopropylether, benzoinisobutylether or the like.

As non-limiting examples, the titanocene-based compound may be dicyclopentadienyl-Ti-dichloride, dicyclopentadienyl-Ti-diphenyl, dicyclopentadienyl-Ti-bis(2,3,4,5,6-pentafluorophenyl), dicyclopentadienyl-Ti-bis(2,3,5,6-tetrafluorophenyl), dicyclopentadienyl-Ti-bis(2,4,6-trifluorophenyl), dicyclopentadienyl-Ti-bis(2,6-difluorophenyl), dicyclopentadienyl-Ti-bis(2,4-difluorophenyl), bis(methylcyclopentadienyl)-Ti-bis(2,3,4,5,6-pentafluorophenyl), bis(methylcyclopentadienyl)-Ti-bis(2,3,5,6-tetrafluorophenyl), bis(methylcyclopentadienyl)-Ti-bis(2,4,6-trifluorophenyl), bis(methylcyclopentadienyl)-Ti-bis(2,6-difluorophenyl), bis(methylcyclopentadienyl)-Ti-bis(2,4-difluorophenyl) or the like.

As non-limiting examples, the oxadiazole-based compound may be 2-phenyl-5-trichloromethyl-1,3,4- oxadiazole, 2-(p-methylphenyl)-5-trichloromethyl-1,3,4-oxadiazole, 2-(p-methoxyphenyl)-5-trichloromethyl-1,3,4-oxadiazole, 2-styryl-5-trichloromethyl-1,3,4-oxadiazole, 2-(p-methoxystyryl)-5-trichloromethyl-1,3,4-oxadiazole, 2-(p-butoxystyryl)-5-trichloromethyl-1,3,4-oxadiazole or the like.

As non-limiting examples, the thioxanthone-based compound may be thioxanthone, 2,4-diethylthioxanthone, isopropyl thioxanthone, 2,4-diisopropylthioxanthone, 2-chlorothioxanthone, 1-chloro-4-propoxythioxanthone, 2-(3-dimethylamino-2-hydroxypropoxy)-3,4-dimethyl-9H-thioxanthone-9-one methochloride or the like.

As non-limiting examples, the (bis)acylphosphineoxide-based compound may be 2,4,6-trimethylbenzoyldiphenylphosphineoxide; bis(2,6-dimethoxybenzoyl)-2,4,4-trimethylpentylphosphineoxide, bis(2,6-dichlorobenzoyl)phenylphosphineoxide, bis(2,6-dichlorobenzoyl)-2,5-dimethylphenylphosphineoxide, bis(2,4,6-trimethylbenzoyl)phenylphosphineoxide or the like.

As non-limiting examples, the organic boron salt compound may be a quaternary organic boron salt compound represented by Formula 1 below:

Formula 1

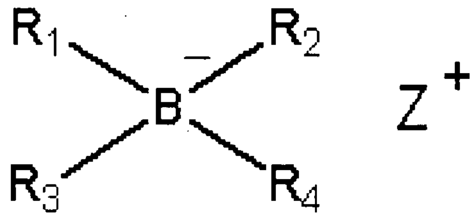

wherein each of $R_1$, $R_2$, $R_3$, and $R_4$ is independently, in each case optionally substituted, an alkyl group, an aryl group, an aralkyl group, an alkenyl group, an alkynyl group, a silyl group, a heterocyclic group, or a halogen atom, and $Z^+$ represents an arbitrary positive ion.

The organic boron salt compound comprises a quaternary organic boron negative ion and a positive ion $Z^+$. In Formula 1, each of $R_1$, $R_2$, $R_3$, and $R_4$ is independently an alkyl group, an aryl group, an aralkyl group, an alkenyl group, an alkynyl group, a silyl group, a heterocyclic group, or a halogen atom, and these groups may have substituents if needed. As non-limiting examples, the substituents may be a methyl group, an ethyl group, an n-propyl group, an isopropyl group, an n-butyl group, a sec-butyl group, an isobutyl group, a tert-butyl group, an n-octyl group, an n-dodecyl group, a cyclopentyl group, a cyclohexyl group, a phenyl group, a tolyl group, a xylyl group, an anisyl group, a biphenyl group, a diphenylmethyl group, a methoxy group, an ethoxy group, an n-propoxy group, an isopropoxy group, an n-butoxy group, a sec-butoxy group, an isobutoxy group, a tert-butoxy group, a methylenedioxy group, an ethylenedioxy group, a phenoxy group, a naphthoxy group, a benzyloxy group, a methylthio group, a phenylthio group, a 2-furyl group, a 2-thienyl group, a 2-pyridyl group, a boron group or the like.

As non-limiting examples, the quaternary organic boron negative ion of the organic boron salt compound may be methyltriphenylborate, n-butyltriphenylborate, n-octyltriphenylborate, n-dodecyltriphenylborate, sec-butyltriphenylborate, tert-butyltriphenylborate, benzyltriphenylborate, n-butyltri(p-anisyl)borate, n-octyltri(p-anisyl)borate, n-dodecyltri(p-anisyl)borate, n-butyltri(p-tolyl)borate, n-butyltri(o-tolyl)borate, n-butyltri(4-tert-butylphenyl)borate, n-butyltri(4-fluoro-2-methylphenyl)borate, n-butyltri(4-fluorophenyl)borate, n-butyltri(1-naphthyl)borate, ethyltri(1-naphthyl)borate, n-butyltri[1-(4-methylnaphthyl)]borate, methyltri[1-(4-methylnaphthyl)]borate, triphenylsilyltriphenylborate, trimethylsilyltriphenylborate, tetra-n-butylborate, di-n-butyldiphenylborate, tetrabenzylborate or the like. In $R_1$, $R_2$, $R_3$, and $R_4$ of the quaternary organic boron negative ion, it is preferred, but not necessary in all aspects, that $R_1$ be an alkyl group, and $R_2$, $R_3$, and $R_4$ be a naphthyl group in order to maintain balance of stability and photoreactivity of the organic boron salt compound.

As non-limiting examples, the positive ion $Z^+$ of the organic boron salt compound may be tetramethylammonium, tetraethylammonium, tetra-n-butylammonium, tetraoctylammonium, N-methylquinolinium, N-ethylquinolinium, N-methylpyridinium, N-ethylpyridinium, tetramethylphosphonium, tetra-n-butylphosphonium, trimethylsulfonium, triphenylsulfonium, trimethylsulfoxonium, diphenyliodonium, di(4-tert-butylphenyl)iodonium, Li positive ion, Na positive ion, K positive ion or the like.

The photoinitiator may be used in combination with a sensitizer for obtaining a higher sensitivity. The selection of the sensitizer depends on the photoinitiator, and some of the photoinitiators described above may also function as a sensitizer of other photoinitiators. For example, when an imidazole-based photoinitiator is used, a benzophenone-based or thioxanthone-based compound functions as both a photoinitiator and a sensitizer, and thus may be used in combination. A sensitizer that can be used in combination with the organic boron salt compound may be any material that can absorb light and decompose the organic boron salt compound. As non-limiting examples, compounds having such functions may be selected from a benzophenone-based compound, a thioxanthone-based compound, a quinone-based compound, and positive ionic dyes. The benzophenone-based compound and the thioxanthone-based compound may be selected from the compounds described above. The quinone-based compound may be quinhydrone, 2,5-dichloro-1,4-benzoquinone, 2,6-dichloro-1,4-benzoquinone, phenyl-1,4-benzoquinone, 2-methyl-1,4-naphthoquinone, 2,3-dichloro-1,4-naphthoquinone, 2-hydroxy-1,4-naphthoquinone, 5-hydroxy-1,4-naphthoquinone, 2-amino-3-chloro-1,4-naphthoquinone, 2-chloro-3-morpholino-1,4-naphthoquinone, anthraquinone, 2-methylanthraquinone, 2-ethylanthraquinone, 2-tert-butylanthraquinone, 2,3-dimethylanthraquinone, 1-chloroanthraquinone, 2-chloroanthraquinone, 1,4-dichloroanthraquinone, 2-(hydroxymethyl)anthraquinone, 9,10-phenanthrenquinone or the like. The positive ionic dyes may be a dye having a maximum absorption wavelength within the range of 300 nm to near-infrared wavelengths, and may be generally yellow, orange, red, green or blue. Examples of the positive ionic dyes may include Basic yellow 11, Astrazon orange G, Thioflavin T, Auramine O, Indocyanine green, 1,1',3,3,3',3'-hexamethylindocarbocyanine iodine, IR-786 perchlorate and the like.

The amount of the photoinitiator may be 1-20 parts by weight with respect to 100 parts by weight of the organic

mixture. When the amount of the photoinitiator is less than 1 part by weight with respect to 100 parts by weight of the organic mixture, the light exposure sensitivity is reduced. When the amount of the photoinitiator is greater than 20 parts by weight with respect to 100 parts by weight of the organic mixture, even a non-exposed region is not developed.

As non-limiting examples, the cross-linking agent can comprise mono(meth)acrylates and multi-functional (meth)acrylates. The mono(meth)acrylates may be, but are not limited to, (meth)acrylic acid, methyl (meth)acrylate, ethyl (meth)acrylate, n-propyl (meth)acrylate, isopropyl (meth)acrylate, n-butyl (meth)acrylate, sec-butyl (meth)acrylate, isobutyl (meth)acrylate, tert-butyl (meth)acrylate, n-pentyl (meth)acrylate, allyl (meth)acrylate, phenyl (meth)acrylate, benzyl (meth)acrylate, butoxyethyl (meth)acrylate, butoxytriethyleneglycol (meth)acrylate, cyclohexyl (meth)acrylate, dicyclopentanyl (meth)acrylate, dicyclopentenyl (meth)acrylate, 2-ethylhexyl (meth)acrylate, glycerol (meth)acrylate, glysidyl (meth)acrylate, isobornyl (meth)acrylate, isodecyl (meth)acrylate, isooctyl (meth)acrylate, lauryl (meth)acrylate, 2-methoxyethyl (meth)acrylate, methoxyethyleneglycol (meth)acrylate, methoxydiethyleneglycol (meth)acrylate, phenoxyethyl (meth)acrylate, stearyl (meth)acrylate, 1-naphthyl (meth)acrylate, 2-naphthyl (meth)acrylate, 2-hydroxyethyl (meth)acrylate, 2-hydroxypropyl (meth)acrylate, aminoethyl (meth)acrylate, and the like. The multi-functional (meth) acrylates may be, but are not limited to, di(meth)acrylates such as 1,6-hexanediol diacrylate, (ethoxylated) 1,6-hexanediol di(meth)acrylate, 1,4-butanediol di(meth)acrylate, 2-butyl-2-ethyl-1,3-propanediol di(meth)acrylate, 1,9-nonanediol di (meth)acrylate, tripropyleneglycol di(meth)acrylate, dipropyleneglycol di(meth)acrylate, tetraethyleneglycol di(meth)acrylate, $(ethoxylated)_n$ (n = 2 to 8) bisphenol A di(meth)acrylate, or bisphenol A epoxy di(meth)acrylate; triacrylates such as trimethylolpropane tri(meth)acrylate, (ethoxylated) trimethylolpropane tri(meth)acrylate, (propoxylated) glycerin tri (meth)acrylate, pentaerythriotol tri(meth)acrylate, or (propoxylated) trimethylolpropane-3-tri(meth)acrylate; tetra(meth) acrylates such as ditrimethylolpropane tetra(meth)acrylate, tetramethylolpropane tetra(meth)acrylate, or pentaerythriotol tetra(meth)acrylate; penta(meth)acrylates such as pentaerythriotol penta(meth)acrylate; hexa(meth)acrylates such as pentaerythriotol hexa(meth)acrylate, or the like. The cross-linking agent may be at least one selected from the group consisting of the mono and multi-functional (meth)acrylates described above.

The amount of the cross-linking agent may be 15-60 parts by weight with respect to 100 parts by weight of the organic mixture. When the amount of the cross-linking agent is less than 15 parts by weight with respect to 100 parts by weight of the organic mixture, the light exposure sensitivity is reduced. When the amount of the cross-linking agent is greater than 60 parts by weight with respect to 100 parts by weight of the organic mixture, the barrier rib may be detached or disconnected in the sintering process.

The photosensitive paste composition may further comprise additives. As non-limiting examples, the additives can be a polymerization inhibitor and antioxidant that improves the storage stability of the photosensitive paste composition, an ultraviolet absorbent that improves the resolution, an antifoaming agent that reduces air bubbles in the composition, a dispersant that improves dispersibility, a leveling agent that improves the smoothness of the membrane during printing, a plasticizer that improves the thermal decomposition characteristics, a thixotropic agent that provides the thixotropy characteristics, or the like.

The solvent may be a solvent that does not reduce the dispersibility of the metal oxide, dissolves the binder and the photoinitiator, is satisfactorily mixed with the cross-linking agent and extra additives, and has a low boiling point of at least 150°C. When the boiling point of the solvent is less than 150°C, the possibility of volatilization is high in the process of preparing the photosensitive paste composition, particularly in a 3-roll mill process, and the solvent may be volatilized so quickly during printing that the print state is not good. The solvent that can satisfy the conditions described above may be, but is not limited to, at least one selected from the group consisting of ethyl carbitol, butyl carbitol, ethyl carbitol acetate, butyl carbitol acetate, texanol, terpine oil, diethylene glycol, dipropylene glycol, tripropylene glycol, dipropyleneglycol methylether, dipropyleneglycol ethylether, dipropyleneglycol monomethylether acetate, γ-butyrolactone, cellosolve acetate and butyl cellosolve acetate.

The amount of the solvent is not particularly limited, but the solvent should be used in a sufficient amount to provide a viscosity of the paste suitable for printing or coating.

The photosensitive paste composition of the present invention can be prepared by using the following procedures.

First, a metal oxide sol is prepared. The metal oxide sol is prepared by preparing a metal oxide precursor and then dispersing it in an organic mixture. The organic mixture comprises a binder, a photoinitiator, a cross-linking agent and additives, and may comprise a solvent if needed. The organic mixture is prepared as a uniform and transparent solution such that each component of the organic mixture is mixed and fully stirred.

The prepared metal oxide sol is mixed with an inorganic material to prepare the paste. The paste may be mixed using a planetary mixer (PLM) or the like, and then mechanically mixed thoroughly by 3-roll milling. When the process of 3-roll milling is terminated, the resultant is filtered using, for example, a stainless steel (SUS) mesh #400 filter, and then degassed using a vacuum pump to prepare a photosensitive paste composition.

Embodiments of the present invention provide a barrier rib of a plasma display panel (PDP), which is prepared using the photosensitive paste composition. A method of preparing the barrier rib of the PDP using the photosensitive paste composition is as follows. The photosensitive paste composition is coated onto a lower substrate of a PDP on

which address electrodes and a dielectric layer have been formed, using screen printing or a table coater. The coated substrate is then dried in a dry oven or an IR oven at 80 to 120°C for 5 to 60 minutes to remove most of the solvent from the photosensitive paste composition. Then, a light of a predetermined wavelength is irradiated onto the dried film using an ultraviolet exposure device in which a photomask is installed. A portion of the dried film onto which ultraviolet rays are irradiated becomes insoluble in a developing solution through cross-linking. Then, in a developing process, an appropriate alkaline developer such as a $Na_2CO_3$ solution, a KOH solution, a TMAH solution, a monoethanolamine solution or the like, which has been diluted in pure water, is used at a developing temperature of about 30°C to remove an unexposed portion of the photosensitive paste. As a result, a pattern is obtained. The resultant is sintered in an electric furnace at 500 to 600°C for 5 to 60 minutes to remove remaining organic mixtures and to sinter the glass frit having a low melting point. Accordingly, a patterned barrier rib can be obtained.

Embodiments of the present invention also provide a PDP including the barrier rib. FIG. 1 shows the structure of a PDP including a barrier rib that has been formed using a photosensitive paste composition according to an embodiment of the present invention.

The PDP includes a front panel 110 and a rear panel 120. The front panel 110 includes a front substrate 111; sustain electrode pairs (114 for each) formed on a rear surface 111a of the front substrate 111, each sustain electrode pair 114 including a Y electrode 112 and an X electrode 113; a front dielectric layer 115 covering the sustain electrode pairs; and a protective layer 116 covering the front dielectric layer 115. The Y electrode 112 and the X electrode 113 respectively include transparent electrodes 112b and 113b made of a transparent conductive material such as, for example, ITO, etc., and bus electrodes 112a and 113a each consisting of a black electrode (not shown) for contrast enhancement and a white electrode (not shown) for imparting conductivity. The bus electrodes 112a and 113a are connected to connection cables (not shown) disposed on the left and right sides of the PDP.

The rear panel 120 includes a rear substrate 121; address electrodes (122) formed on a front surface 121 a of the rear substrate 121 so as to intersect with the sustain electrode pairs; a rear dielectric layer 123 covering the address electrodes; a barrier rib 124 formed on the rear dielectric layer 123 so as to partition discharge cells (126); and a phosphor layer 125 disposed in the discharge cells. The address electrodes 122 are connected to connection cables disposed on upper and lower sides of the PDP.

Hereinafter, embodiments of the present invention will be described more specifically with reference to the following Examples. The following Examples are for illustrative purposes and are not intended to limit the scope of the invention.

## Examples

Preparation of metal oxide precursor

### Example 1. Preparation of a tantalum oxide precursor using tantalum (V) ethoxide

100 ml of n-BuOH and 100 ml of diethylene glycol were added to a reaction container equipped with a thermometer and a stirrer, and stirred. During stirring, 10 ml of 1.0 N HCl was slowly added to the mixture. After stirring for about 30 minutes, 10.0 g of tantalum ethoxide was slowly added to the mixture while stirring. Then, the resulting mixture was stirred at room temperature for 12 hours to complete hydrolysis and a condensation reaction, and then 0.1 g of bis (polyoxyethylene polycyclic phenylether) methacrylate sulfuric ester salt was added to the resulting mixture as a surface modifier and the resultant was stirred at room temperature for 6 hours. n-BuOH and pure water were removed using vacuum distillation to prepare a tantalum oxide precursor using diethylene glycol as a dispersion medium.

### Example 2. Preparation of a titanium oxide precursor using titanium (VI) chloride

100 ml of n-BuOH and 100 ml of tripropylene glycol were added to a reaction container equipped with a thermometer and a stirrer, and stirred. During stirring, 10 ml of 28% ammonia water was slowly added to the mixture. After stirring for about 30 minutes, 1p.0 g of titanium (VI) chloride was slowly added to the mixture while stirring. Then, the resulting mixture was stirred at room temperature for 6 hours to complete hydrolysis and a condensation reaction. n-BuOH and pure water were removed using vacuum distillation to prepare a titanium oxide precursor using tripropylene glycol as a dispersion medium.

### Example 3. Preparation of a zirconium oxide precursor using zirconium (VI) n-propoxide

100 ml of n-propanol and 100 ml of dipropylene glycol were added to a reaction container equipped with a thermometer and a stirrer, and stirred. During stirring, 5 ml of 1.0 N HCl was slowly added to the mixture. After stirring for about 30 minutes, 10.0 g of zirconium (VI) n-propoxide was slowly added to the mixture while stirring. Then, the

resulting mixture was stirred at room temperature for 24 hours to complete hydrolysis and a condensation reaction. n-propanol and pure water were removed using vacuum distillation to prepare a zirconium oxide precursor using dipropylene glycol as a dispersion medium.

Example 4. Preparation of a silicon oxide precursor using tetraethoxy silane

100 ml of ethanol and 100 ml of dipropylene glycol were added to a reaction container equipped with a thermometer and a stirrer, and stirred. During stirring, 5 ml of 1.0 N HCl was slowly added to the mixture. After stirring for about 30 minutes, 10.0 g of tetraethoxy silane was slowly added to the mixture while stirring. Then, the resulting mixture was stirred at room temperature for 6 hours to complete hydrolysis and a condensation reaction. Ethanol and pure water were removed using vacuum distillation to prepare a silicon oxide precursor using dipropylene glycol as a dispersion medium.

Example 5. Preparation of aluminum oxide precursor using aluminum (III) isopropoxide

100 ml of isopropanol and 100 ml of tripropylene glycol were added to a reaction container equipped with a thermometer and a stirrer, and stirred. During stirring, 5 ml of 1.0 N HCl was slowly added to the mixture. After stirring for about 30 minutes, 10.0 g of aluminum (III) isopropoxide was slowly added to the mixture while stirring. Then, the resulting mixture was stirred at room temperature for 6 hours to complete hydrolysis and a condensation reaction. Isopropanol and pure water were removed using vacuum distillation to prepare an aluminum oxide precursor using dipropylene glycol as a dispersion medium.

Example 6. Preparation of a tantalum-titanium oxide precursor using tantalum (V) ethoxide and titanium (VI) chloride

100 ml of ethanol and 100 ml of diethylene glycol were added to a reaction container equipped with a thermometer and a stirrer, and stirred. During stirring, 5 ml of 1.0 N HCl was slowly added to the mixture. After stirring for about 30 minutes, 5.0 g of tantalum (V) ethoxide and 5.0 g of titanium (VI) chloride were slowly added to the mixture while stirring. Then, the resulting mixture was stirred at room temperature for 12 hours to complete hydrolysis and a condensation reaction. Ethanol and pure water were removed using vacuum distillation to prepare a tantalum-titanium oxide precursor using diethylene glycol as a dispersion medium.

Example 7. Preparation of a silicon-titanium oxide precursor using tetraethoxy silane and titanium (VI) chloride

100 ml of ethanol and 100 ml of diethylene glycol were added to a reaction container equipped with a thermometer and a stirrer, and stirred. During stirring, 10 ml of 28% ammonia water was slowly added to the mixture. After stirring for about 30 minutes, 5.0 g of tetraethoxy silane and 5.0 g of titanium (VI) chloride were slowly added to the mixture while stirring. Then, the resulting mixture was stirred at room temperature for 6 hours to complete hydrolysis and a condensation reaction, and then 0.1 g of bis(methacryloxyethyl)phosphate was added to the resulting mixture as a surface modifier and the resultant was stirred at room temperature for 6 hours. Ethanol and pure water were removed using vacuum distillation to prepare a silicon-titanium oxide precursor using diethylene glycol as a dispersion medium.

Measurement of physical properties of metal oxide precursors

Results of measuring light refractive indices, specific gravities and average particle diameters of metal oxides of the metal oxide precursors prepared in Examples 1 through 7 are shown in Table 1 below. The values of the light refractive indices and specific gravities were measured at 20°C, and the average particle diameters were measured using photon correlation spectroscopy (PCS).

Table 1

| Metal oxide | Refractive index (@ 20°C) | Specific gravity (@ 20°C) | Average particle diameter (nm) |
|---|---|---|---|
| Example 1 | 2.27 | 8.11 | 14.8 |
| Example 2 | 2.48 | 3.94 | 15.2 |
| Example 3 | 2.08 | 5.76 | 8.6 |
| Example 4 | 1.47 | 2.23 | 12.4 |
| Example 5 | 1.75 | 3.88 | 13.5 |

(continued)

| Metal oxide | Refractive index (@ 20°C) | Specific gravity (@ 20°C) | Average particle diameter (nm) |
|---|---|---|---|
| Example 6 | 2.39 | 6.05 | 7.5 |
| Example 7 | 1.99 | 3.11 | 9.3 |

Preparation of organic mixture

An organic mixture to be used for preparing a metal oxide sol by dispersing the metal oxide precursor prepared as above in the organic mixture, was prepared as follows.

Example 8. Preparation of organic mixture 1

Organic mixture 1 was prepared by mixing 47.2% by weight of a poly(methylmethacrylate-co-n-butylmethacrylate-co-methacrylic acid) copolymer having a weight average molecular weight of 5,000 g/mol and an acid value of 120 mg KOH/g as a binder, 3.5% by weight of 2-benzyl-2-dimethylamino-1-(4-morpholinophenyl)-1-butanone as a photoinitiator, 46.8% by weight of trimethylolpropaneethoxylated triacrylate as a cross-linking agent, and 2.5% by weight of benzotriazol as a storage stabilizer.

Example 9. Preparation of organic mixture 2

Organic mixture 2 was prepared by mixing 44.1% by weight of a poly(styrene-co-methacrylic acid) copolymer having a weight average molecular weight of 12,000 g/mol and an acid value of 210 mg KOH/g as a binder 4.4% by weight of benzotriazol as a storage stabilizer" 5.5% by weight of 2-benzyl-2-dimethylamino-1-(4-morpholinophenyl)-1-butanone as a photoinitiator, 27.0% by weight of bisphenol A modified epoxy diacrylate as a cross-linking agent, and 19.0% by weight of tripropylene glycol as a solvent.

Measurement of physical properties of organic mixtures

Results of measuring light refractive indices and specific gravities of the organic mixtures prepared in Examples 8 and 9 are shown in Table 2 below.

Table 2

| Organic mixture | Refractive index (@20°C) | Specific gravity (@ 20°C) |
|---|---|---|
| Organic mixture 1 | 1.50 | 1.07 |
| Organic mixture 2 | 1.55 | 1.10 |

Preparation of metal oxide sol

The metal oxide precursors of Examples 1 through 7 were dispersed in the organic mixtures of Examples 8 and 9 to prepare metal oxide sols. Each metal oxide sol was prepared using the following procedure: first, the organic mixture was added to a stirring container and stirred, and a calculated amount of the metal oxide precursor was slowly added thereto during stirring, then the mixture was stirred for several hours to prepare a transparent metal oxide sol.

Example 10. Preparation of metal oxide sol 1

The tantalum oxide precursor of Example 1 and organic mixture 1 of Example 8 were mixed at a volume ratio of 20:80, wherein the volume of the tantalum oxide precursor was based only on the volume of tantalum oxide in the tantalum oxide precursor. The refractive index measured after mixing was 1.66.

Example 11. Preparation of metal oxide sol 2

The titanium oxide precursor of Example 2 and organic mixture 1 of Example 8 were mixed at a volume ratio of 15:85, wherein the volume of the titanium oxide precursor based only on the volume of titanium oxide in the titanium oxide precursor. The refractive index measured after mixing was 1.65.

Example 12. Preparation of metal oxide sol 3

The zirconium oxide precursor of Example 3 and organic mixture 2 of Example 9 were mixed at a volume ratio of 20:80, wherein the calculation of the volume of the zirconium oxide precursor was based only on the volume of zirconium oxide in the zirconium oxide precursor and the volume of organic mixture 2 was measured without the solvent. The refractive index measured after mixing was 1.66.

Example 13. Preparation of metal oxide sol 4

The silicon oxide precursor of Example 4 and organic mixture 2 of Example 9 were mixed at a volume ratio of 10:90, wherein the volume of the silicon oxide precursor was based only on the volume of silicon oxide in the silicon oxide precursor and the volume of organic mixture 2 was measured without the solvent. The refractive index measured after mixing was 1.54.

Example 14. Preparation of metal oxide sol 5

The aluminum oxide precursor of Example 5 and organic mixture 2 of Example 9 were mixed at a volume ratio of 20:80, wherein the volume of the aluminum oxide precursor was based only on the volume of aluminum oxide in the aluminum oxide precursor and the volume of organic mixture 2 was measured without the solvent The refractive index measured after mixing was 1.60.

Example 15. Preparation of metal oxide sol 6

The tantalum-titanium oxide precursor of Example 6 and organic mixture 1 of Example 8 were mixed at a volume ratio of 15:85, wherein the volume of the tantalum-titanium oxide precursor was based only on the volume of tantalum-titanium oxide in the tantalum-titanium oxide precursor. The refractive index measured after mixing was 1.64.

Example 16. Preparation of metal oxide sol 7

The silicon-titanium oxide precursor of Example 7 and organic mixture 2 of Example 9 were mixed at a volume ratio of 20:80, wherein the volume of the silicon-titanium oxide precursor was based only on the volume of silicon-titanium oxide of the silicon-titanium oxide precursor and the volume of organic mixture 2 was measured without the solvent. The refractive index measured after mixing was 1.64.

Preparation of photosensitive paste composition

Photosensitive paste compositions were prepared by mixing the metal oxide sols of Examples 10 through 16 with an inorganic material comprising a glass frit having a low melting point and a glass frit having a high melting point as described below.

Example 17. Preparation of photosensitive paste composition 1

A photosensitive paste composition 1 was prepared by mixing 40% by volume of the metal oxide sol of Example 10, 55% by volume of a glass frit having a low melting point (ZnO-BaO-$B_2O_3$-based, amorphous, $D_{50}$ = 3.2 μm, refractive index = 1.68, specific gravity = 3.86), and 5% by volume of a glass frit having a high melting point ($SiO_2$-$B_2O_3$-$Al_2O_3$-based, amorphous, $D_{50}$ = 2.5 μm, refractive index = 1.67, specific gravity = 3.67).

Examples 18 through 23. Preparation of photosensitive paste compositions 2 through 7

Photosensitive paste compositions 2 through 7, respectively, were prepared in the same manner as photosensitive paste composition 1, except that the metal oxide sols of Examples 11 through 16, respectively, were used instead of the metal oxide sol of Example 10.

Comparative Example 1. Preparation of photosensitive paste composition according to prior art

A photosensitive paste composition comprising 40% by volume of the organic mixture of Example 9, 55% by volume of a glass frit having a low melting point ($Li_2O$-$SiO_2B_2O_3$-based, amorphous, $D_{50}$ = 3.2 μm, refractive index = 1.56, specific gravity = 2.56), and 5% by volume of a glass frit having a high melting point ($SiO_2B_2O_3$-$Al_2O_3$-based,

amorphous, $D_{50}$ = 3.0 μm, refractive index = 1.55, specific gravity = 2.52) was prepared as a control.

Evaluation and result of photosensitive paste compositions

The photosensitive paste compositions of Examples 17 through 23 and Comparative Example 1, respectively, were coated onto a glass substrate using a coater, and then dried in a dry oven at 100°C for 30 minutes. Subsequently, 300-1500 mJ/$cm^2$ of light was irradiated using a high voltage mercury lamp ultraviolet exposure device equipped with a photomask having a grating pattern (width : linewidth = 40 μm (pitch = 160 μm), length : linewidth = 40 μm (pitch = 560 μm). The light-irradiated glass substrate was developed by spraying 0.4% by weight of aqueous $Na_2CO_3$ solution thereonto at 30°C at a nozzle pressure of 1.2 kgf/$cm^2$ for 180 seconds, and then rinsed by spraying pure water at room temperature at a nozzle pressure of 1.2 kgf/$cm^2$ for 30 seconds. Subsequently, the developed glass substrate was dried using an air knife and then placed into an electric furnace and sintered at 560°C for 20 minutes to form a barrier rib. Then, the formed barrier rib was evaluated using an optical microscope and scanning electron microscopy (SEM). The evaluation results are shown in Table 3 below. In Table 3, the term "optimum exposure amount" refers to a value that provides optimum pattern results. The terms "surface roughness" and "surface compactness" refer to qualities obtained by observation using SEM. The value for the surface compactness was obtained calculating an area of an empty space in an unit area of a cross-section of the barrier rib, and subtracting the calculated area of empty space from the unit area. That is, when the surface compactness is 100%, an empty space does not exist at all in the cross-section of the barrier rib, indicating that a compact barrier rib is formed.

Table 3

| Paste composition | Optimum exposure amount (mJ/$cm^2$) | Sintered membrane thickness (μm) | Upper width (after sintering) (μm) | Lower width (after sintering) (μm) | Surface roughness (±μm) | Surface compactnesss (%) |
|---|---|---|---|---|---|---|
| Example 17 | 550 | 117 | 35 | 50 | 1.5 | 97 |
| Example 18 | 750 | 116 | 37 | 46 | 1.4 | 98 |
| Example 19 | 550 | 115 | 34 | 49 | 1.6 | 99 |
| Example 20 | 1400 | 45 | 70 | 35 | 1.6 | 99 |
| Example 21 | 1300 | 114 | 72 | 32 | 1.7 | 97 |
| Example 22 | 900 | 116 | 52 | 50 | 1.5 | 98 |
| Example 23 | 850 | 118 | 52 | 54 | 1.4 | 98 |
| Comparative Example 1 | 400 | 115 | 34 | 54 | 2.2 | 92 |

From the results of Table 3, the photosensitive paste composition of Comparative Example 1, which did not contain a metal oxide, exhibited the best exposure sensitivity (optimum exposure amount). This is because if a photosensitive paste composition includes a metal oxide, the amount of an organic mixture involved in a photoreaction is relatively low, and the metal oxide absorbs irradiated ultraviolet rays. In particular, the titanium oxide exhibited much less exposure sensitivity. The photosensitive paste composition of Example 20 exhibited the least exposure sensitivity, and also had the lowest height, that is, 45 μm, of a barrier rib formed by a single exposure to light. This is assumed to be due to a relatively big difference between the light refractive index of the metal oxide sol and that of the inorganic material. In addition, as shown in Table 3, the lower the exposure sensitivity, the larger the upper width and the narrower the lower width of the barrier rib. This is because the bigger the difference is between the refractive index of a metal oxide sol and that of an inorganic material, the lower the transmittance of light irradiated in an exposure process, while reflection and scattering are increased. Since the photosensitive paste composition of Comparative Example 1 does not contain a metal oxide, the exposure sensitivity is relatively excellent, while the surface roughness and compactness are low. This suggests that a metal oxide decomposes an organic mixture in a sintering process, and then the empty space is filled with a glass frit having a low melting point during sintering.

Manufacture of a PDP and evaluation of characteristics thereof

The photosensitive paste compositions of Examples 17 through 19 and Comparative Example 1, respectively,

were used to manufacture a 6" panel. The 6" panel was manufactured in a pilot line to have specs for a 42" HD type panel. The results of evaluating the luminances of the manufactured panels are shown in Table 4 below.

Table 4

| Photosensitive paste composition | Measured luminance (lm/W) |
|---|---|
| Example 17 | 1.28 |
| Example 18 | 1.37 |
| Example 19 | 1.30 |
| Comparative Example 1 | 1.12 |

From the luminance results of Table 4, it can be seen that the photosensitive paste compositions of the present invention exhibit a luminance increasing effect compared with the photosensitive paste composition of Comparative Example 1. Without being bound to any particular theory, it is believed that this result occurs because when a metal oxide sol is used, the metal oxide formed in the barrier rib increases the reflective index of visible rays, and thus luminance is increased, the roughness of a barrier rib itself is reduced and compactness thereof becomes excellent.

According to embodiments of the present invention, since a pattern of a barrier rib for a PDP having high resolution and high precision can be made by a process that includes only a single exposure to light, and a barrier rib having a higher reflective index than a conventional barrier rib can also be provided, a PDP including the barrier rib can have a high luminance.

Although a few embodiments of the present invention have been shown and described, it would be appreciated by those skilled in the art that changes may be made to these embodiments without departing from the principles of the invention, the scope of which is defined in the claims and their equivalents.

## Claims

1. A photosensitive paste composition comprising:

   a metal oxide sol material comprising a metal oxide dispersed in an organic mixture; and
   an inorganic material,

   wherein the average optical refractive index ($N_1$) of the metal oxide sol and the average optical refractive index ($N_2$) of the inorganic material satisfy Equation 1 below:

   Equation 1

   $$-0.2 \leq N_1 - N_2 \leq 0.2$$

2. A photosensitive paste composition according to claim 1, wherein a metal component of the metal oxide is at least one selected from the group consisting of Si, Ti, Al, Zr, Ta, Ge, Y and Zn.

3. A photosensitive paste composition according to claim 1 or 2, wherein the metal oxide sol is prepared by preparing a metal oxide precursor from an alkoxide or halide compound using hydrolysis and condensation, and dispersing the prepared metal oxide precursor in the organic mixture.

4. A photosensitive paste composition according to any preceding claim, wherein the metal oxide has an average particle diameter of 1-60 nm.

5. A photosensitive paste composition according to any preceding claim wherein the metal oxide sol has an average light refractive index of 1.4-2.0.

6. A photosensitive paste composition according to any preceding claim, wherein the metal oxide has an average light refractive index of 1.3-3.0.

7. A photosensitive paste composition according to any preceding claim, wherein the average light refractive index ($N_1$) of the metal oxide sol and the average light refractive index ($N_2$) of the inorganic material satisfy Equation 2 below:

Equation 2

$$-0.1 \leq N_1 - N_2 \leq 0.1$$

8. A photosensitive paste composition according to any preceding claim, wherein the amount of the metal oxide of the metal oxide sol is 3-30 parts by volume with respect to 100 parts by volume of the inorganic material.

9. A photosensitive paste composition according to any preceding claim, wherein the amount of the metal oxide of the metal oxide sol is 5-50 parts by volume with respect to 100 parts by volume of the organic mixture.

10. A photosensitive paste composition according to any preceding claim, wherein the inorganic material has an average light refractive index $N_2$ in the range of 1.5-1.8.

11. A photosensitive paste composition according to any preceding claim, wherein the inorganic material comprises a glass frit having a low melting point and a glass frit having a high melting point, wherein the softening temperature Ts of the glass frit having a low melting point satisfies Equation 5, below, and the softening temperature Ts of the glass frit having a high melting point satisfies Equation 6 below:

Equation 5

Sintering temperature - 80°C < Ts < sintering temperature,

Equation 6

Ts > sintering temperature + 20°C.

12. A photosensitive paste composition according to claim 11, wherein the average particle diameter of the glass frit having a low melting point has a median value $D_{50}$ of 2-5 $\mu$m, a minimum value $D_{min}$ of 0.1 $\mu$m and a maximum value $D_{max}$ of 20 $\mu$m.

13. A photosensitive paste composition according to claim 11 or 12, wherein the amount of the glass frit having a low melting point is 70-100 parts by volume with respect to 100 parts by volume of the inorganic material.

14. A photosensitive paste composition according to any of claims 11 - 13, wherein the glass frit having a low melting point comprises a compound selected from a $PbO-B_2O_3$ based glass, a $PbO-SiO_2-B_2O_3$ based glass, a $Bi_2O_3-B_2O_3$ based glass, a $Bi_2O_3-SiO_2-B_2O_3$ based glass, a $SiO_2-B_2O_3-Al_2O_3$ based glass, a $SiO_2-B_2O_3-BaO$ based glass, a $SiO_2-B_2O_3-CaO$ based glass, a $ZnO-B_2O_3-Al_2O_3$ based glass, a $ZnO-SiO_2-B_2O_3$ based glass, a $P_2O_5$ based glass, a $SnO-P_2O_5$ based glass, a $V_2O_5-P_2O_5$ based glass, a $V_2O_5-Mo_2O_3$ based glass, and a $V_2O_5-P_2O_5-TeO_2$ based glass.

15. A photosensitive paste composition according to any of claims 11 - 14, wherein the average particle diameter of the glass frit having a high melting point has a median value of 1-4 $\mu$m, a minimum value of 0.1 $\mu$m and a maximum value of 20 $\mu$m.

16. A photosensitive paste composition according to any of claims 11 - 15, wherein the amount of the glass frit having a high melting point is 0-30 parts by volume with respect to 100 parts by volume of the inorganic material.

17. A photosensitive paste composition according to any of claims 11 - 16, wherein the glass frit having a high melting point comprises a compound selected from a $SiO_2-B_2O_3-BaO$ based glass, a $SiO_2-B_2O_3-CaO$ based glass, a $SiO_2-B_2O_3-MgO$ based glass, a $SiO_2-B_2O_3-CaO-BaO$ based glass, a $SiO_2-B_2O_3-CaO-MgO$ based glass, a $SiO_2-Al_2O_3-BaO$ based glass, a $SiO_2-Al_2O_3-CaO$ based glass, a $SiO_2-Al_2O_3-MgO$ based glass, a $SiO_2-Al_2O_3-BaO-$

CaO based glass, a $SiO_2$-$Al_2O_3$-CaO-MgO based glass.

**18.** A photosensitive paste composition according to any of claims 11 - 17, wherein the difference between a refractive index $N_3$ of the glass frit having a low melting point and the refractive index $N_4$ of the glass frit having a high melting point satisfies Equation 7 below:

Equation 7

$$-0.2 \leq N_3 - N_4 \leq 0.2.$$

**19.** A photosensitive paste composition according to claim 18, wherein the difference between the refractive index $N_3$ of the glass frit having a low melting point and the refractive index $N_4$ of the glass frit having a high melting point satisfies Equation 8 below:

Equation 8

$$-0.1 \leq N_3 - N_4 \leq 0.1.$$

**20.** A photosensitive paste composition according to any preceding claim, wherein the organic mixture comprises a binder, a photoinitiator and a cross-linking agent.

**21.** A photosensitive paste composition according to claim 20, wherein the amount of the binder is 30-80 parts by weight with respect to 100 parts by weight of the organic mixture; the amount of photoinitiator is 1-20 parts by weight with respect to 100 parts by weight of the organic mixture; and the amount of the cross-linking agent is 15-60 parts by weight with respect to 100 parts by weight of the organic mixture.

**22.** A photosensitive paste composition according to claim 20 or 21, wherein the organic mixture further comprises an additive and a solvent, wherein the additive is at least one additive selected from the group consisting of a polymerization inhibitor, an antioxidant, an ultraviolet absorbent, an antifoaming agent, a dispersant, a leveling agent, a plasticizer, and a thixotropic agent.

**23.** A photosensitive paste composition according to any of claims 20 - 22, wherein:

the binder is an acryl-based resin having a carboxyl group formed by copolymerization of a monomer having a carboxyl group and at least one monomer having an ethylenically unsaturated group;
the binder has a weight average molecular weight of 500-100,000 g/mol, and an acid value of 50-300 mg KOH/g;
the monomer having a carboxyl group is at least one selected from the group consisting of an acrylic acid, a methacrylic acid, a fumaric acid, a maleic acid, a vinylacetic acid, and an anhydride thereof; and
the ethylenically unsaturated monomer is at least one selected from the group consisting of methyl(meth)acrylate, ethyl(meth)acrylate, n-propyl(meth)acrylate, isopropyl(meth)acrylate, n-butyl(meth)acrylate, sec-butyl(meth)acrylate, isobutyl(meth)acrylate, tert-butyl(meth)acrylate, n-pentyl(meth)acrylate, allyl(meth)acrylate, phenyl(meth)acrylate, benzyl(meth)acrylate, butoxyethyl(meth)acrylate, butoxytriethyleneglycol(meth)acrylate, cyclohexyl(meth)acrylate, dicyclopentanyl(meth)acrylate, dicyclopentenyl(meth)acrylate, 2-ethylhexyl(meth)acrylate, glycerol(meth)acrylate, glycidyl(meth)acrylate, isobornyl(meth)acrylate, isodecyl(meth)acrylate, isooctyl(meth)acrylate, lauryl(meth)acrylate, 2-methoxyethyl(meth)acrylate, methoxyethyleneglycol(meth)acrylate, methoxydiethyleneglycol(meth)acrylate, phenoxyethyl(meth)acrylate, stearyl(meth)acrylate, 1-naphthyl(meth)acrylate, 2-naphthyl(meth)acrylate, 2-hydroxyethyl(meth)acrylate, 2-hydroxypropyl(meth)acrylate, aminoethyl(meth)acrylate, styrene, $\alpha$-methylstyrene, $\alpha$-2-dimethylstyrene, 3-methylstyrene and 4-methylstyrene.

**24.** A photosensitive paste composition according to claim 23, wherein the binder further comprises at least one selected from the group consisting of cellulose, methylcellulose, ethylcellulose, n-propylcellulose, hydroxyethylcellulose, 2-hydroxyethylcellulose, methyl-2-hydroxyethylcellulose, hydroxypropylcellulose, hydroxypropylmethylcellulose, hydroxybutylmethylcellulose, hydroxypropylmethylcellulose phthalate, cellulose nitrate, cellulose acetate, cellulose triacetate, cellulose acetate butylate, cellulose acetate hydrogenphthalate, cellulose acetate propionate, cellulose

propionate, (acrylamidomethyl)cellulose acetate propionate, (acrylamidomethyl)cellulose acetate butylate, cyanoethylate cellulose, pectic acid, chitosan, chitin, carboxymethylcellulose, carboxymethylcellulose sodium salt, carboxyethylcellulose, and carboxyethylmethylcellulose.

**25.** A photosensitive paste composition according to any of claims 20 - 24, wherein the photoinitiator is at least one selected from the group consisting of:

(i) an imidazole-based compound, (ii) a triazine-based compound, (iii) an aminoacetophenone compound, (iv) a benzophenone and acetophenone based compound, (v) a benzoin-based compound, (vi) a titanocene-based compound, (vii) an oxadiazole-based compound, (viii) a thioxanthone-based compound, (ix) a (bis)acylphosphineoxide-based compound, and (x) an organic boron salt compound.

**26.** A photosensitive paste composition according to any of claims 20 - 25, wherein the cross-linking agent is at least one selected from the group consisting of:

at least one mono(meth)acrylate selected from the group consisting of (meth)acrylic acid, methyl (meth)acrylate, ethyl (meth)acrylate, n-propyl (meth)acrylate, isopropyl (meth)acrylate, n-butyl (meth)acrylate, sec-butyl (meth) acrylate, isobutyl (meth)acrylate, tert-butyl (meth)acrylate, n-pentyl (meth)acrylate, allyl (meth)acrylate, phenyl (meth)acrylate, benzyl (meth)acrylate, butoxyethyl (meth)acrylate, butoxytriethyleneglycol (meth)acrylate, cyclohexyl (meth)acrylate, dicyclopentanyl (meth)acrylate, dicyclopentenyl (meth)acrylate, 2-ethylhexyl (meth) acrylate, glycerol (meth)acrylate, glysidyl (meth)acrylate, isobornyl (meth)acrylate, isodecyl (meth)acrylate, isooctyl (meth)acrylate, lauryl (meth)acrylate, 2-methoxyethyl (meth)acrylate, methoxyethyleneglycol (meth)acrylate, methoxydiethyleneglycol (meth)acrylate, phenoxyethyl (meth)acrylate, stearyl (meth)acrylate, 1-naphthyl (meth)acrylate, 2-naphthyl (meth)acrylate, 2-hydroxyethyl (meth)acrylate, 2-hydroxypropyl (meth)acrylate and aminoethyl (meth)acrylate;
at least one di(meth)acrylate selected from the group consisting of 1,6-hexanediol di(meth)acrylate, (ethoxylated) 1,6-hexanediol di(meth)acrylate, 1,4-butanediol di(meth)acrylate, 2-butyl-2-ethyl-1,3-proponediol di(meth)acrylate, 1,9-nonanediol di(meth)acrylate, tripropyleneglycol di(meth)acrylate, dipropyleneglycol di(meth)acrylate, tetraethyleneglycol di(meth)acrylate, $(ethoxylated)_n$ (n = 2 to 8) bisphenol A di(meth)acrylate, and bisphenol A epoxy di(meth)acrylate;
at least one tri(meth)acrylate selected from the group consisting of trimethylolpropane tri(meth)acrylate, (ethoxylated) trimethylolpropane tri(meth)acrylate, (proxylated) glycerin tri(meth)acrylate, pentaerythritol tri(meth)acrylate, and (proxylated) trimethylolpropane-3-tri(meth)acrylate;
at least one tetra(meth)acrylate selected from the group consisting of ditrimethylolpropane tetra(meth)acrylate, tetramethylolpropane tetra(meth)acrylate, and pentaerythritol tetra(meth)acrylate;
at least one penta(meth)acrylate; and
at least one hexa(meth)acrylate.

**27.** A photosensitive paste composition according to any of claims 22 - 26, wherein the additive is at least one additive selected from the group consisting of a polymerization inhibitor, an antioxidant, an ultraviolet absorbent, an antifoaming agent, a dispersant, a leveling agent, a plasticizer, and a thixotropic agent.

**28.** A photosensitive paste composition according to any of claims 22 - 27, wherein the solvent is at least one selected from the group consisting of ethyl carbitol, butyl carbitol, ethyl carbitol acetate, butyl carbitol acetate, texanol, terpine oil, diethylene glycol, dipropylene glycol, tripropylene glycol, dipropyleneglycol methylether, dipropyleneglycol ethylether, dipropyleneglycol monomethylether acetate, y-butyrolactone, cellosolve acetate and butyl cellosolve acetate.

**29.** A barrier rib of a PDP prepared using a photosensitive paste composition according to any of claims 1 - 28.

**30.** A PDP comprising the barrier rib according to claim 29.

FIG. 1

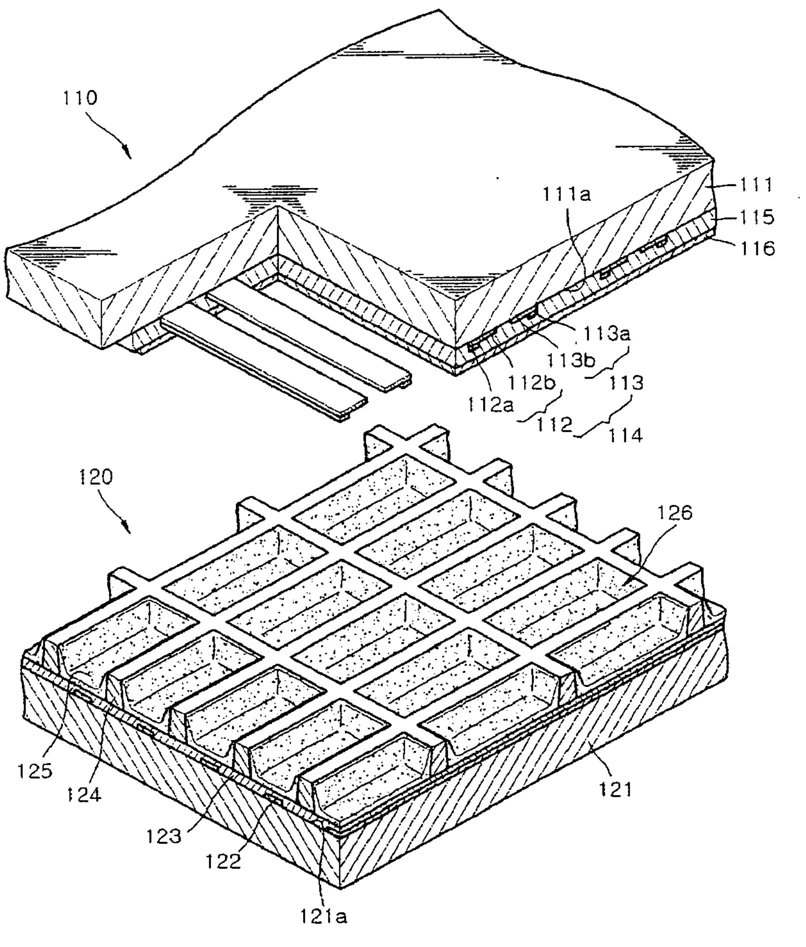
110
111
111a
115
116
113a
113b
113
112b
112a
112
114
120
126
125
124
123
122
121
121a

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 5209688 A
- US 6197480 B
- US 6507148 B
- US 6576391 B
- JP 11102645 A
- JP 2000290040 A
- JP 2004318116 A
- JP 2002122985 A